# EUROPEAN PATENT SPECIFICATION

(11) **EP 3 989 366 B1**
(45) Date of publication and mention of the grant of the patent: **27.11.2024**
(21) Application number: 21202222.2
(22) Date of filing: 12.10.2021
(51) Int. Cl.: H05K 3/34

(54) **ELECTRICAL CONTROL PANEL FOR CONNECTOR TERMINALS, ELECTRICAL CONTROL CABINET, AND AIR CONDITIONER**
ELEKTRISCHES SCHALTFELD FÜR VERBINDERANSCHLÜSSE, ELEKTRISCHER SCHALTSCHRANK UND KLIMAANLAGE
PANNEAU DE COMMANDE ÉLECTRIQUE POUR BORNES DE CONNECTEUR, ARMOIRE DE COMMANDE ÉLECTRIQUE ET CLIMATISEUR

(30) Priority: 23.10.2020 CN 202022395633 U
(43) Date of publication of application: 27.04.2022
(73) Proprietor: Guangdong Giwee Technology Co., Ltd., Foshan (CN)
(72) Inventor: KAIQIN, Feng, Foshan (CN)
(74) Representative: Dehns

(56) References cited:
- DE-C2- 4 434 064
- GB-A- 2 164 803
- KR-B1- 101 250 658
- US-A1- 2014 117 825
- KONTRON: "Hardware Handbuch für PiXtend eIO", 18 October 2019 (2019-10-18), pages 1 - 100, XP055897351, Retrieved from the Internet <URL:https://cdn-reichelt.de/documents/datenblatt/A300/PIXTEND_EIO_HARDWARE_MANUAL_DE.pdf> [retrieved on 20220303]
- SINGH SHIKHA ET AL: "Improved Power Quality Switched-Mode Power Supply Using Buck-Boost Converter", IEEE TRANSACTIONS ON INDUSTRY APPLICATIONS, IEEE SERVICE CENTER, PISCATAWAY, NJ, US, vol. 52, no. 6, 1 November 2016 (2016-11-01), pages 5194 - 5202, XP011634740, ISSN: 0093-9994, [retrieved on 20161118], DOI: 10.1109/TIA.2016.2600675

## Description

The present invention relates to the technical field of air conditioning systems, and in particular to an electrical control panel for connector terminals, an electrical control cabinet, and an air conditioner.

Air conditioning, or air conditioners, refer to devices regulating and controlling parameters such as the temperature, humidity, and flow of the air in a building or structure by man-made means.

Air conditioners are composed of four parts: a cooling system, an air duct system, an electrical system, and a cabinet and a panel. The cooling system is the refrigeration and cooling part of the air conditioner, and it is a sealed refrigeration cycle composed of a refrigeration compressor, a condenser, capillary tubes, an evaporator, a solenoid directional valve, a filter, and refrigerant. The air duct system is the part of the air conditioner that accelerates the heat exchange of air, and it is composed of devices such as a centrifugal blower and an axial flow fan. The electrical system is the part in the air conditioner that controls the temperature and causes the compressor and fan to operate safely, and it is composed of a motor, a thermostat, a relay, a capacitor, and a heater. The cabinet and panel are the air conditioner's framework, various components and supports, and parts directing the airflow, and they are composed of a cabinet, a panel, and louvers.

However, the sockets disposed on the motherboard body of a traditional air conditioner require providing extra terminal blocks matched to the sockets, and they require custom-made wiring sets to connect the sockets to the terminal blocks. The addition of terminal blocks means increased electrical control cabinet volume, which leads to additional costs.

An objective of at least the example embodiments of this invention is: to provide an electrical control panel for connector terminals, an electrical control cabinet, and an air conditioner, with the aim of resolving the problem of the sockets disposed on the motherboard body of traditional air conditioners requiring the addition of extra terminal blocks and requiring custom-made wiring sets, increasing electrical control cabinet volume and thereby increasing costs. The invention is defined by the subject-matter of claim 1.

According to the invention, there is provided an electrical control cabinet including a cabinet body and an electrical control panel according to the subject-matter of claim 1.

Optionally, a strong current area and/or weak current area are disposed on the motherboard body, and if the strong current area and the weak current area are simultaneously present, the strong current area and the weak current area are spaced apart, and the strong current area and the weak current area each have a connector terminal body.

Optionally, a strong current wire terminal is disposed on the strong current area, and a weak current wire terminal is disposed on the weak current area.

Optionally, the control switches on the connector terminal body may be lever-style switches, the connector terminal body has an in-use position and an idle position, when the control switches are in the in-use position, the wires inserted into the connector terminal are in a compressed state, and when the control switches are in the idle position, the wires inserted into the connector terminal are in a loosened state.

Optionally, springs are disposed within the sliding grooves, and the ends of the spring are connected to the sliding groove and the first clamping block.

According to a third aspect, an air conditioner is provided according to the subject-matter of claim 6.

Prior art document GB2164803A discloses an electrical control cabinet with electrical control panels.

Compared to prior art, the benefits of this invention are: a connector terminal body is disposed on the motherboard body of this invention, and the control switch can compress or loosen the conducting wire inserted into the connection port, reducing the number of hard connections, reducing the volume of the electrical control cabinet, lowering material costs, simplifying wiring, saving time, and reducing the cost of labor.

In the above discussion, weak current may be electricity meeting certain safety criteria. The references to weak current may be understood to define electricity used for information transmission. This is in contrast to strong current, which may for example be electricity used for power transmission. Weak current may be DC, and/or may be below 24 volts. Strong current may be AC and/or may be 100 volts or higher.

The following is a more detailed exemplary description of this invention provided by way of example only, based on the drawings and embodiments.

Figure 1 is a schematic diagram of an electrical control panel for connector terminals, an electrical control cabinet and an air conditioner.

Figure 2 is a schematic diagram of the body of the electrical control panel for connector terminals, the electrical control cabinet and the body of the connector terminals of the air conditioner.

Figure 3 is a schematic diagram of a clamping block of the control panel for connector terminals, the electrical control cabinet and the air conditioner.

Figure 4 is a schematic diagram, from another angle, of the clamping block of the control panel for connector terminals, the electrical control cabinet and the air conditioner.

In the figures:
100, motherboard body; 200, connector terminal body; 201, connection port; 202, control switch; 300, electrical control cabinet; 301, clamping slot; 302, sliding groove; 303, clamping block.

In order to clarify the technical problem addressed, the technical schemes employed, and the technical effects achieved by this invention, the technical schemes of the embodiments of this invention are described in further detail below. Clearly, the embodiments described are merely a portion of the embodiments of this invention, and are not all of the embodiments. All other embodiments based on the claims of this invention and obtained by a person skilled in the art without the expenditure of creative labor shall fall within the scope of protection of this invention as defined by the claims.

In the descriptions of this invention, unless otherwise explicitly stipulated and defined, the terms "linked", "connected", and "fixed" should be broadly interpreted. For example, it can be a fixed connection or a detachable connection, or it can form one integrated body. It can be a mechanical connection or an electrical connection. It can be direct linkage or indirectly through an intermediary element. It can be the internal linkage of two elements or an interactive relationship between two elements. For persons having ordinary skill in the art, the specific meaning of these terms in this invention can be understood based on the specific circumstances.

In this invention, unless otherwise explicitly stipulated and defined, when a first feature is "above" or "below" a second feature, it can include direct contact between the first and second features, and it can also include the first and second feature not being in direct contact but being in contact through another feature between them. Also, a first feature being "on top of', "on", and "above" a second feature includes the first feature being directly above and diagonally above the second feature, or it merely indicates that the height of the first feature is higher than the second feature. The first feature being "beneath", "under" and "below" the second feature includes the first feature being directly below and diagonally below the second feature, or it merely indicates that the height of the first feature is lower than the second feature.

The sockets disposed on the motherboard body of a traditional air conditioner require extra terminal blocks matched to the sockets, and they require custom-made wiring sets to connect the sockets to the terminal blocks. The addition of terminal blocks means increased electrical control cabinet volume, which leads to additional costs.

This invention replaces sockets connected to terminal blocks with a connector terminal body 200, and the control switch 202 can compress or loosen the conducting wire inserted into the connection port 201, reducing the number of hard connections, reducing the volume of the electrical control cabinet 300, lowering material costs, simplifying wiring, saving time, and reducing the cost of labor.

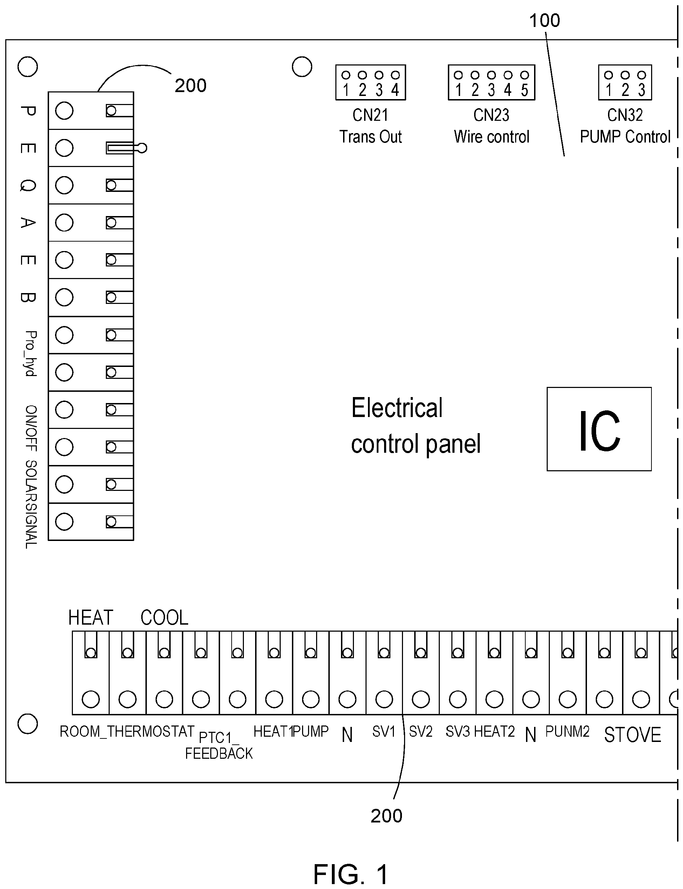

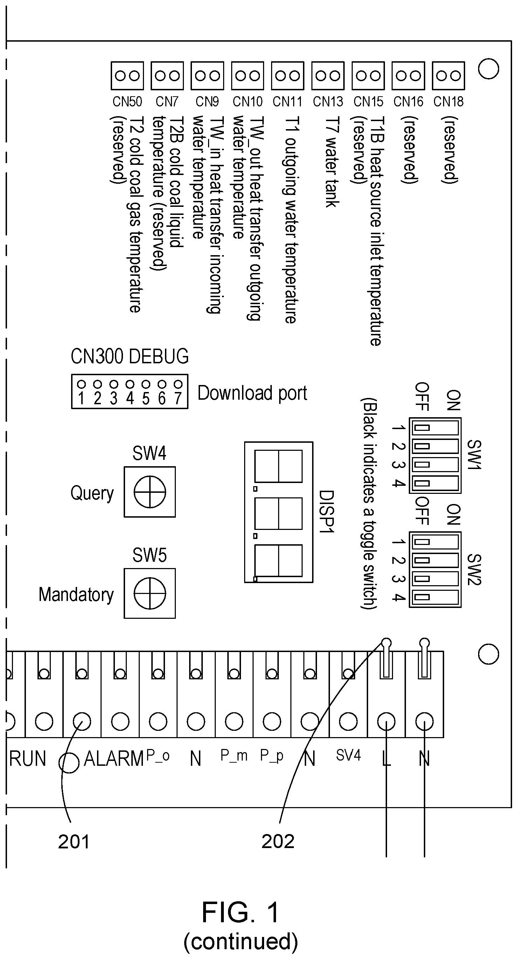

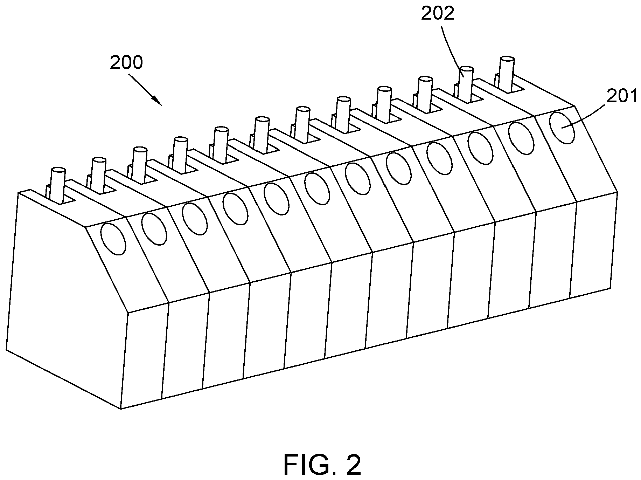

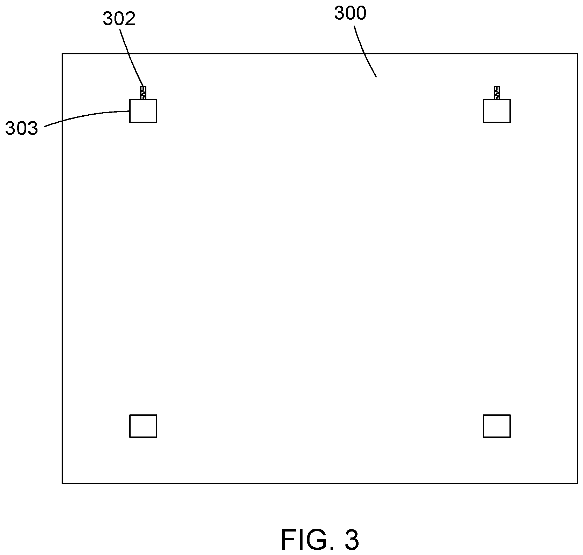

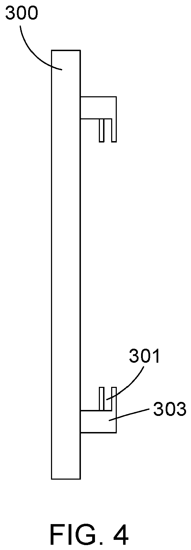

In this invention, Figure 1 is a schematic diagram of an electrical control panel for connector terminals, an electrical control cabinet 300 and the air conditioner; Figure 2 is a schematic diagram of the connector terminal body 200 of the control panel for connector terminals, the electrical control cabinet 300 and the air conditioner body; Figure 3 is a schematic diagram of the clamping block 303 of the control panel for connector terminals, the electrical control cabinet 300 and the air conditioner; Figure 4 is a schematic diagram, from another angle, of the clamping block 303 of the control panel for connector terminals, the electrical control cabinet 300 and the air conditioner.

As shown in Figure 1, this embodiment provides an electrical control panel for connector terminals, including:
a motherboard body 100;
a connector terminal body 200, wherein the connector terminal body 200 is disposed on the motherboard body 100, there is at least one connector terminal body 200, a plurality of connection ports 201 and control switches 202 corresponding to the connection ports 201 are disposed on the connector terminal body 200, the connection ports 201 are connected to the components of the motherboard body 100, and the control switches 202 act to compress or loosen conducting wires.

In this invention, the preferred model of the connector terminal body 200 is HP-T6003, rated 300V, 8A; the diameter of the conducting wire inserted into the connection port 201 is 0.3~0.75mm; PA66 is used as the material of the connector terminal body 200.

It can be understood that the connector terminal body 200 is soldered to the motherboard body 100, the connector terminal body 200 employs a base plate-style terminal block, the connection port 201 on the connector terminal body 200 corresponds to the control switch 202, the connector terminal body 200 has an in-use position and an idle position, when the control switch 202 is in the in-use position, the conducting wire inserted into the connection port 201 is in a compressed state, and when the control switch 202 is in the idle position, the conducting wire inserted into access the connection port 201 is in a loosened state.

When the connector terminal body 200 is disposed axially or longitudinally along the motherboard body 100, and it is correspondingly connected to the components on the motherboard body 100, it can be understood that compared to having sockets on a traditional motherboard body 100, wherein the sockets must be equipped with matching terminal blocks, the connector terminal is characterized by reducing the number of hard connections, reducing the size of the electrical control cabinet 300, lowering material costs, simplifying wiring, saving time, and reducing the cost of labor.

In this invention, a strong current area and/or weak current area are disposed on the motherboard body 100, and if both the strong current area and the weak current area are present, the strong current area and the weak current area are spaced apart, and the strong current area and the weak current area each has a connector terminal body 200.

When a strong current area and a weak current area are disposed on the motherboard body 100, maximizing the distance between the strong current area and the weak current area can achieve the separation of the strong current area and the weak current area connected to the motherboard body 100, thereby avoiding signal interference, improving the stability of the air conditioner's operation, and eliminating safety hazards.

Furthermore, a strong current wire terminal is disposed on the strong current area, and a weak current wire terminal is disposed on the weak current area.

Specifically, the strong current area has other components such as relays, the weak current area has circuits or components such as communication circuits, and the strong current wire terminal and weak current wire terminal have corresponding connector terminals; the strong current wire terminal and weak current wire terminal are spaced apart, to avoid interference between the strong and weak current elements and improve operational stability.

Here, the control switch 202 on the connector terminal body 200 may be a lever-style switch, the connector terminal body 200 has an in-use position and an idle position, when the control switch 202 is in the in-use position, the wire inserted into the connector terminal is in a compressed state, and when the control switch 202 is in the idle position, the wire inserted into the connector terminal is in a loosened state

It can be understood that the connector terminal body 200 must be able to withstand high temperatures in the preheating zone and temperatures conducted to the connector terminal body 200 through wave soldering throughout the entire assembly process; solder must not affect the connector terminal body 200, it must be easily removed, and there must be no residue.

An electrical control cabinet 300 includes a cabinet body and the electrical control panel for connector terminals according to any of the above items; the cabinet body has a holding cavity, a plurality of clamping blocks are disposed on the inner wall of the holding cavity 303, and the plurality of clamping blocks 303 are distributed around the motherboard body 100 and are fitted with the motherboard body 100, such that the motherboard body 100 is connected to the cabinet body.

The clamping blocks 303 are disposed on the inner walls of the side plates of the holding cavity. In this embodiment, there can be four clamping blocks 303, and the four clamping blocks 303 are positioned at the four corners of the motherboard body 100.

It can be understood that there can also be three clamping blocks 303, with the three clamping blocks 303 disposed around the motherboard body 100, and the clamping blocks 303 disposed at the side walls of the motherboard body 100. One clamping block 303 can be disposed at the middle of the upper end of the motherboard body 100, and two clamping blocks 303 can be disposed at the lower end of the motherboard body 100.

The distance between the clamping block 303 located at the upper end of the motherboard body 100 and the clamping blocks 303 located at the lower end of the motherboard body 100 is not greater than the distance between the upper and lower ends of the motherboard body 100, ensuring that the clamping block 303 can clamp the motherboard body 100 inside the electrical control cabinet 300.

Furthermore, the clamping blocks 303 include a first clamping block and a second clamping block located at opposite ends of the motherboard body 100, the clamping blocks 303 have clamping slots 301, and the side walls of the motherboard body 100 are clamped inside the clamping slots 301.

Specifically, the first clamping block and the second clamping block both have a clamping slot 301, the clamping slot 301 is U-shaped, and the opening of the clamping slot 301 is disposed in the direction of the side wall of the motherboard body 100.

The radius of the opening of the clamping slot 301 is not less than the thickness of the motherboard body 100, and when the motherboard body 100 is disposed within the clamping slot 301, there is a certain space between the motherboard body 100 and the inner walls of the electrical control cabinet 300, ensuring the safe use of the motherboard body 100 and anti-interference capability.

In this invention, sliding grooves 302 are disposed on the inner wall of the holding cavity, the sliding grooves 302 are distributed along the axis of the holding cavity, and the first clamping block is slidably connected inside the sliding grooves 302.

As shown in Figure 3, the number of sliding grooves 302 is set as needed, and there can be one or two. In this embodiment, two sliding grooves 302 are employed, and the two sliding grooves 302 located on the same side of the motherboard body 100 are positioned on the same horizontal line.

It can be understood that the clamping blocks 303 located on the same side of the motherboard body 100 are both positioned on the same horizontal line, such that when the motherboard body 100 is disposed within the clamping slots 301, it will not tilt.

Furthermore, springs are disposed within the sliding grooves 302, and the ends of the springs are connected to the sliding grooves (302) and the first clamping block.

Specifically, when there are springs between the sliding grooves 302 and the first clamping block, the springs are in their original state or a slightly compressed state. In a more advantageous scheme, when there are springs between the sliding grooves 302 and the first clamping block, the springs are in a slightly compressed state, which can more tightly clamp the motherboard body 100.

An air conditioner, includes:
a plurality of connector terminal electrical control panels according to any of the above items, and;
a plurality of electrical control cabinets 300 according to any of the above items.

In the descriptions herein, it must be understood that terms of an orientational or positional relationship such as "above", "below", "left", and "right" are used solely to facilitate description and simplify operation, and do not indicate or imply that the referenced equipment or elements must have a specific orientation or be constructed and operated at a specific orientation; therefore, they must not be interpreted as limiting this invention. In addition, the terms "first" and "second" are merely used to provide descriptive differentiation and have no special implications.

In the descriptions of this Specification, the reference terms "one embodiment" and "example" mean that a specific characteristic, structure, material, or feature described by the embodiment or example is contained within at least one embodiment or example of this invention. In this Specification, illustrative expressions of these terms do not necessarily refer to the same embodiment or example.

In addition, it should be understood that, even though this Specification provides descriptions by means of implementation, it is not the case that every implementation contains only one independent technical scheme. This narrative form of the Specification is merely for the sake of clarity. A person skilled in the art should take the Specification as a whole. The technical schemes in the various embodiments may be appropriately combined, to form other implementations understandable to a person skilled in the art.

In combination with specific embodiments, the above describes the technical principles of this invention. These descriptions are solely for the purpose of explaining the principles of this invention, and must not, by any means, be interpreted as limiting the scope of protection of this invention. The scope of protection of this invention is defined by the claims.

## Claims

1. An electrical control cabinet (300) comprising a cabinet body and an electrical control panel for connector terminals, wherein the electrical control panel for connector terminals comprises:
a motherboard body (100); and
a connector terminal body (200), wherein the connector terminal body (200) is disposed on the motherboard body (100), wherein there is at least one connector terminal body (200), wherein a plurality of connection ports (201) and control switches (202) corresponding to the connection ports (201) are disposed on the connector terminal body (200), the connection ports (201) are connected to components of the motherboard body (100), and the control switches (202) act to compress or loosen conducting wires;
**characterized in that**
the cabinet body has a holding cavity, a plurality of clamping blocks (303) are disposed on an inner wall of the holding cavity, and the plurality of clamping blocks are distributed around the motherboard body (100) and are fitted with the motherboard body (100) such that the motherboard body (100) is connected to the cabinet body; and
wherein the clamping blocks (303) comprise a first clamping block and a second clamping block located at opposite ends of the motherboard body (100), the clamping blocks (303) have clamping slots (301), and side walls of the motherboard body (100) are clamped inside the clamping slots (301);
wherein
sliding grooves (302) are disposed on the inner wall of the holding cavity, the sliding grooves (302) are distributed along an axis of the holding cavity, and the first clamping block (303) is slidably connected inside the sliding grooves (302).

2. The electrical control cabinet according to claim 1, wherein a strong current area and/or a weak current area are disposed on the motherboard body (100), and if both the strong current area and the weak current area are present, the strong current area and the weak current area are spaced apart, and the strong current area and the weak current area each has a connector terminal body (200).

3. The electrical control cabinet according to claim 2, wherein a strong current wire terminal is disposed on the strong current area, and a weak current wire terminal is disposed on the weak current area.

4. The electrical control cabinet according to any of claims 1-3, wherein the control switches (202) on the connector terminal body (200) may be lever-style switches, the connector terminal body (200) has an in-use position and an idle position, when the control switches (202) are in the in-use position, the wires inserted into the connector terminal (201) are in a compressed state, and when the control switches (202) are in the idle position, the wires inserted into the connector terminal (201) are in a loosened state.

5. The electrical control cabinet (300) according to any preceding claim, wherein springs are disposed within the sliding grooves (302), and the ends of the springs are connected to the sliding grooves (302) and the first clamping block (303).

6. An air conditioner, comprising:
a plurality of electrical control cabinets (300) according to any preceding claim.

## Patentansprüche

1. Elektrischer Schaltschrank (300), umfassend einen Schrankkörper und ein elektrisches Schaltfeld für Verbinderanschlüsse, wobei das elektrische Schaltfeld für Verbinderanschlüsse Folgendes umfasst:
einen Hauptplatinenkörper (100); und
einen Verbinderanschlusskörper (200), wobei der Verbinderanschlusskörper (200) an dem Hauptplatinenkörper (100) angeordnet ist, wobei mindestens ein Verbinderanschlusskörper (200) vorhanden ist, wobei eine Vielzahl von Verbindungsports (201) und den Verbindungsports (201) entsprechenden Steuerschaltern (202) an dem Verbinderanschlusskörper (200) angeordnet sind, die Verbindungsports (201) mit Komponenten des Hauptplatinenkörpers (100) verbunden sind und die Steuerschalter (202) zum Zusammendrücken oder Entspannen von leitenden Drähten dienen;
**dadurch gekennzeichnet, dass**
der Schrankkörper einen Haltehohlraum aufweist, eine Vielzahl von Klemmblöcken (303) an einer Innenwand des Haltehohlraums angeordnet ist und die Vielzahl von Klemmblöcken um den Hauptplatinenkörper (100) verteilt ist und derart an den Hauptplatinenkörper (100) angepasst ist, dass der Hauptplatinenkörper (100) mit dem Schrankkörper verbunden ist; und
wobei die Klemmblöcke (303) einen ersten Klemmblock und einen zweiten Klemmblock umfassen, die sich an gegenüberliegenden Enden des Hauptplatinenkörpers (100) befinden, die Klemmblöcke (303) Klemmschlitze (301) aufweisen und Seitenwände des Hauptplatinenkörpers (100) innerhalb der Klemmschlitze (301) geklemmt sind;
wobei Gleitnuten (302) an der Innenwand des Haltehohlraums angeordnet sind, die Gleitnuten (302) entlang einer Achse des Haltehohlraums verteilt sind und der erste Klemmblock (303) innerhalb der Gleitnuten (302) verschiebbar verbunden ist.

2. Elektrischer Schaltschrank nach Anspruch 1, wobei eine Starkstromfläche und/oder eine Schwachstromfläche an dem Hauptplatinenkörper (100) angeordnet ist und, wenn sowohl die Starkstromfläche als auch die Schwachstromfläche vorhanden sind, die Starkstromfläche und die Schwachstromfläche voneinander beabstandet sind und die Starkstromfläche und die Schwachstromfläche jeweils einen Verbinderanschlusskörper (200) aufweisen.

3. Elektrischer Schaltschrank nach Anspruch 2, wobei ein Starkstromdrahtanschluss an der Starkstromfläche angeordnet ist und ein Schwachstromdrahtanschluss an der Schwachstromfläche angeordnet ist.

4. Elektrischer Schaltschrank nach einem der Ansprüche 1-3, wobei die Steuerschalter (202) an dem Verbinderanschlusskörper (200) hebelartige Schalter sein können, der Verbinderanschlusskörper (200) eine Betriebsstellung und eine Ruhestellung aufweist, sich die in den Verbinderanschluss (201) eingesteckten Drähte, wenn die Steuerschalter (202) in der Betriebsstellung sind, in einem zusammengedrückten Zustand befinden und sich die in den Verbinderanschluss (201) eingesteckten Drähte, wenn die Steuerschalter (202) in der Ruhestellung sind, in einem entspannten Zustand befinden.

5. Elektrischer Schaltschrank (300) nach einem der vorhergehenden Ansprüche, wobei Federn innerhalb der Gleitnuten (302) angeordnet sind und die Enden der Federn mit den Gleitnuten (302) und dem ersten Klemmblock (303) verbunden sind.

6. Klimaanlage, umfassend:
eine Vielzahl von elektrischen Schaltschränken (300) nach einem der vorhergehenden Ansprüche.

## Revendications

1. Armoire de commande électrique (300) comprenant un corps d'armoire et un panneau de commande électrique pour bornes de connecteur, dans laquelle le panneau de commande électrique pour bornes de connecteur comprend :
un corps de carte mère (100) ; et
un corps de terminal de connecteur (200), dans laquelle le corps de terminal de connecteur (200) est disposé sur le corps de carte mère (100), dans laquelle il existe au moins un corps de terminal de connecteur (200), dans laquelle
une pluralité de ports de connexion (201) et de commutateurs de commande (202) correspondant aux ports de connexion (201) sont disposés sur le corps de terminal de connecteur (200), les ports de connexion (201) sont connectés à des composants du corps de carte mère (100), et les commutateurs de commande (202) agissent pour comprimer ou desserrer les fils conducteurs ;
**caractérisée en ce que**
le corps de l'armoire présente une cavité de maintien, une pluralité de blocs de serrage (303) sont disposés sur une paroi intérieure de la cavité de maintien, et la pluralité de blocs de serrage sont répartis autour du corps de carte mère (100) et sont montés sur le corps de carte mère (100) de telle sorte que le corps de carte mère (100) soit connecté au corps de l'armoire ; et
dans laquelle les blocs de serrage (303) comprennent un premier bloc de serrage et un second bloc de serrage situés au niveau des extrémités opposées du corps de carte mère (100), les blocs de serrage (303) présentent des fentes de serrage (301), et les parois latérales du corps de carte mère (100) sont serrées à l'intérieur des fentes de serrage (301) ; dans laquelle
des rainures de coulissement (302) sont disposées sur la paroi intérieure de la cavité de maintien, les rainures de coulissement (302) sont réparties le long d'un axe de la cavité de maintien, et le premier bloc de serrage (303) est relié de manière coulissante à l'intérieur des rainures de coulissement (302).

2. Armoire de commande électrique selon la revendication 1, dans laquelle une zone de courant fort et/ou une zone de courant faible sont disposées sur le corps de carte mère (100), et si à la fois la zone de courant fort et la zone de courant faible sont présentes, la zone de courant fort et la zone de courant faible sont espacées, et la zone de courant fort et la zone de courant faible présentent chacune un corps de borne de connecteur (200).

3. Armoire de commande électrique selon la revendication 2, dans laquelle une borne de fil de courant fort est disposée sur la zone de courant fort, et une borne de fil de courant faible est disposée sur la zone de courant faible.

4. Armoire de commande électrique selon l'une quelconque des revendications 1 à 3, dans laquelle les commutateurs de commande (202) sur le corps de borne de connecteur (200) peuvent être des commutateurs de type levier, le corps de borne de connecteur (200) présente une position d'utilisation et une position de repos, lorsque les commutateurs de commande (202) sont dans la position d'utilisation, les fils insérés dans la borne de connecteur (201) sont dans un état comprimé, et lorsque les commutateurs de commande (202) sont dans la position de repos, les fils insérés dans la borne de connecteur (201) sont dans un état relâché.

5. Armoire de commande électrique (300) selon une quelconque revendication précédente, dans laquelle des ressorts sont disposés à l'intérieur des rainures de coulissement (302), et les extrémités des ressorts sont reliées aux rainures de coulissement (302) et au premier bloc de serrage (303).

6. Climatiseur, comprenant :
une pluralité d'armoires de commande électrique (300) selon une quelconque revendication précédente.
